# EUROPEAN PATENT APPLICATION

(11) **EP 4 664 694 A1**
(43) Date of publication of application: **17.12.2025**
(21) Application number: 23930812.5
(22) Date of filing: 07.11.2023
(51) Int. Cl.: H01S 5/14, G02B 6/26, G02F 1/29

(54) **LIGHT SOURCE DEVICE**

(30) Priority: 28.03.2023 JP 2023051330
(71) Applicant: Hamamatsu Photonics K.K., Hamamatsu-shi, Shizuoka 435-8558 (JP)
(72) Inventor: KATO, Naoaki, Hamamatsu-shi, Shizuoka 435-8558 (JP); TAKIGUCHI, Yuu, Hamamatsu-shi, Shizuoka 435-8558 (JP); TANAKA, Hiroshi, Hamamatsu-shi, Shizuoka 435-8558 (JP)
(74) Representative: Grünecker Patent- und Rechtsanwälte PartG mbB
(86) International application number: PCT/JP2023/040089
(87) International publication number: WO 2024/202183

(57) **Abstract**

A light source apparatus includes: a light source configured to output light; a spatial light modulator including an input unit for a control signal and configured to be able to control distribution of angles at which incident light is reflected based on the control signal; a diffraction grating configured to disperse the light output from the light source to cause the light to be incident on the spatial light modulator, and return at least a part of the light reflected by the spatial light modulator to the light source; and a pinhole configured to cause only a part of the light returned from the diffraction grating in a spatially dispersed state to pass therethrough. In the light source apparatus, an optical resonator is formed by the light source and the spatial light modulator, and the light passing through the pinhole and returned to the light source is output.

## Description

### Technical Field

One aspect of the present disclosure relates to a light source apparatus.

### Background Art

Patent Literature 1 describes a Littman/Metcalf type external resonator semiconductor laser. The external resonator semiconductor laser of Patent Literature 1 is configured to obtain a wide spectrum (bandwidth) by changing an end mirror to a concave mirror and making a curvature radius thereof equal to a distance between the concave mirror and a diffraction grating.

### Citation List

### Patent Literature

Patent Literature 1: Specification of US Patent No. 7245642

### Summary of Invention

### Technical Problem

Herein, in the external resonator semiconductor laser as described above, light dispersed by the diffraction grating is returned by the end mirror, and the light is coupled to a single-mode laser diode (LD) or the like to perform wavelength limitation. Therefore, an element that can be used as a light source is limited.

An aspect of the present disclosure has been made in view of the above circumstances, and provides a light source apparatus in which an element used as a light source is not limited.

### Solution to Problem

(1) A light source apparatus according to one aspect of the present disclosure includes: a light source configured to output light; a reflection unit including an input unit for a control signal and configured to be able to control distribution of angles at which incident light is reflected based on the control signal; a diffraction grating configured to disperse the light output from the light source to cause the light to be incident on the reflection unit, and configured to return, to the light source, at least a part of the light reflected by the reflection unit; and a spatial filter configured to cause only a part of the light returned from the diffraction grating in a spatially dispersed state to pass therethrough. In the light source apparatus 1, an optical resonator including the light source and the reflection unit is formed, and the light passing through the spatial filter and returned to the light source is output.
   In the light source apparatus according to one aspect of the present disclosure, the light output from the light source is dispersed in the diffraction grating and incident on the reflection unit. Then, at least a part of the light reflected by the reflection unit is returned from the diffraction grating to the light source. Herein, the spatial filter that causes only a part of the light returned from the diffraction grating in a spatially dispersed state to pass therethrough is provided between the diffraction grating and the light source, and the light passing through the spatial filter and returned to the light source is output. As described above, since the spatial filter is provided between the diffraction grating and the light source, the wavelength of the light returned to and output from the light source is limited. Since the spatial filter has a wavelength limiting function, the wavelength limiting function is not required for the light source (or the optical fiber added in the optical resonator, or the like), and various light sources can be used. As described above, according to one aspect of the present disclosure, it is possible to provide a light source apparatus in which an element used as the light source is not limited.
(2) In the light source apparatus according to (1), the spatial filter may be a pinhole, a transmission mask, one or a plurality of slits, or a single-mode fiber. Such a configuration can cause only a part of the spatially dispersed light to appropriately pass therethrough.
(3) The light source apparatus according to (1) or (2) may further include a condenser lens configured to condense the light returned from the diffraction grating, wherein the spatial filter is provided at a condensing point of the condenser lens. Such a configuration can appropriately perform wavelength limitation provided by the spatial filter.
(4) In the light source apparatus according to any one of the above (1) to (3), a bandwidth of the light returned from the diffraction grating to the light source may be controlled by controlling distribution of angles of the light reflected by the reflection unit based on the control signal. According to such a configuration, by changing the control signal, the distribution of angles at which the light is reflected by the reflection unit is changed, and the bandwidth of the light returned from the diffraction grating to the light source can be changed. That is, according to such a configuration, the bandwidth of the light returned from the diffraction grating to the light source can be arbitrarily adjusted.

### Advantageous Effects of Invention

According to one aspect of the present disclosure, it is possible to provide a light source apparatus in which an element used as a light source is not limited.

### Brief Description of Drawings

FIG. 1 is a diagram schematically illustrating a light source apparatus according to the present embodiment.
FIG. 2 is a diagram illustrating an example of a modulation pattern displayed on a spatial light modulator.
FIG. 3 is a diagram illustrating the wavelength limiting function of a single-mode LD.
FIG. 4 is a diagram illustrating a spatial filter according to a modification.
FIG. 5 is a diagram illustrating a spatial filter according to a modification.

### Description of Embodiments

Hereinafter, the present embodiment will be described in detail with reference to the drawings. Note that, in the drawings, the same or corresponding parts are denoted by the same reference signs, and redundant description will be omitted.

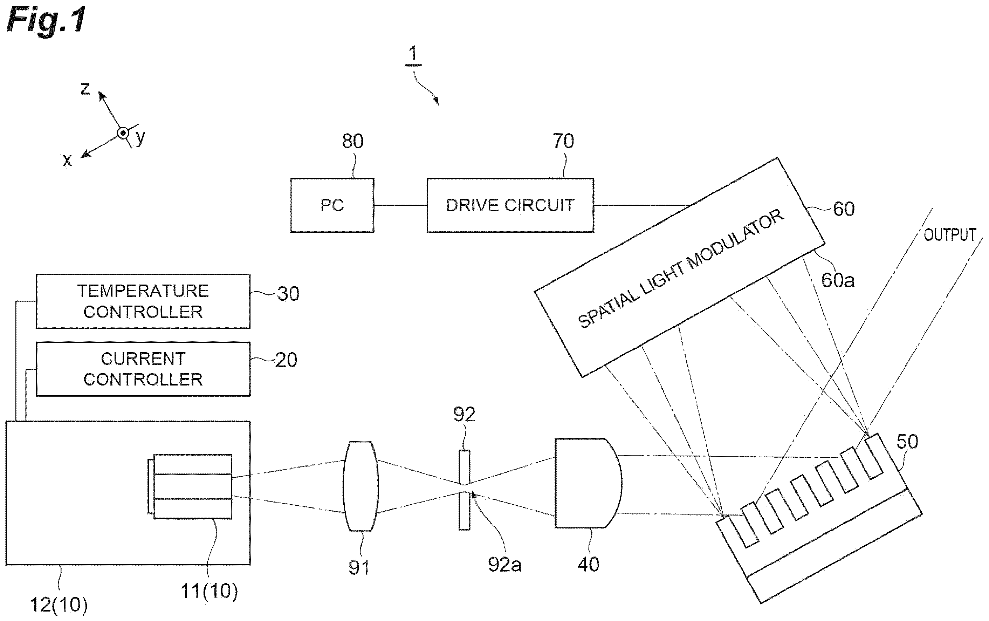

FIG. 1 is a diagram schematically illustrating a light source apparatus 1 according to a first embodiment. The light source apparatus 1 is an external cavity laser (ECL). The light source apparatus 1 is, for example, a Littman-type external cavity laser, and is configured to reflect +1-order light of a diffraction grating by a mirror and return the light into a semiconductor laser.

As illustrated in FIG. 1, the light source apparatus 1 includes a light source unit 10, a current controller 20, a temperature controller 30, a lens 40 (condenser lens), a diffraction grating 50, a spatial light modulator 60 (reflection unit), a drive circuit 70, a PC 80, a lens 91, and a pinhole 92 (spatial filter).

The light source unit 10 includes a light source 11 and an LD mount 12. The light source 11 is, for example, a semiconductor laser (LD: Laser Diode) that outputs light having a spontaneous emission spectrum having a center wavelength of 850 nm. The light source 11 may be, for example, a Fabry-Perot type semiconductor laser. The center wavelength of the light output from the light source 11 may be 10 nm or more and 3 mm or less. An end surface of the light source 11 on a side coupled to an external resonator (light output direction side) may be provided with an antireflection coating. The light source 11 is mounted on the LD mount 12. The LD mount 12 may be a mount with a thermoelectric cooler (TEC). In the light source apparatus 1, an optical resonator is formed by the light source 11 and the spatial light modulator 60 (described later). In the light source apparatus 1, light returned to the light source 11 through the external resonator (light passing through the pinhole 92 and returned to the light source 11) is output.

The current controller 20 is configured to supply a current to the light source 11 via the LD mount 12 to cause the light source 11 to output light. That is, the light source 11 outputs light corresponding to the current (injection current) supplied from the current controller 20. The light source 11 generates laser oscillation or operates at an oscillation threshold or less according to the supplied (injected) current value.

The temperature controller 30 is configured to control heat absorption (or heat dissipation) of the TEC by supplying a current to the TEC provided in the LD mount 12 and to keep a temperature of the light source 11 constant via the TEC.

The lens 40 is a lens that efficiently couples the light output from the light source 11 to the pinhole 92 when the light returns through the diffraction grating 50 and the spatial light modulator 60 (one round in the external resonator). That is, the lens 40 functions as a condenser lens that condenses the light returned from the diffraction grating 50 to the pinhole 92. When the light emitted from the pinhole 92 spreads greatly, a beam diameter and a divergence angle of the light are adjusted by the lens 40. A position of the lens 40 may be fixed at a position where a high light output can be obtained regardless of a focal length of a modulation pattern (phase pattern) displayed on the spatial light modulator 60.

The diffraction grating 50 is configured to disperse light having various wavelengths and output from the light source 11 to cause the light to be incident on the spatial light modulator 60, and return at least a part of the light reflected by the spatial light modulator 60 to the light source 11. In the diffraction grating 50, light is divided for each wavelength, and +1-order light is directed to the spatial light modulator 60 and 0th order light is extracted as output light.

The spatial light modulator 60 includes an input unit for a control signal, and displays the modulation pattern based on the control signal to control the distribution of angles at which the incident light is reflected. The spatial light modulator 60 is, for example, a spatial light modulator (SLM) of a reflective liquid crystal on silicon (LCOS). The modulation pattern (phase pattern) is generated by the PC 80, input from the PC 80 to the drive circuit 70, and displayed on the spatial light modulator 60 based on a control signal from the drive circuit 70. As described above, the control signal input from the drive circuit 70 to the spatial light modulator 60 is a signal related to the display of the modulation pattern.

The spatial light modulator 60 displays, for example, a lens pattern as a modulation pattern. For example, a Fresnel lens pattern may be used as the lens pattern. Hereinafter, in the present embodiment, it is assumed that the lens pattern is a Fresnel lens pattern, but the lens pattern may be other lens pattern such as an aspherical lens pattern. The curvature radius of the Fresnel lens pattern is, for example, a value obtained by doubling the focal length. The curvature radius is a positive value in a case of a concave mirror and a negative value in a case of a convex mirror. The focal length is a positive value in a case of a convex lens and a negative value in a case of a concave lens. In the spatial light modulator 60, the focal length of the Fresnel lens pattern as the modulation pattern is changed, so that the curvature radius of the Fresnel lens pattern is changed, and the distribution of angles of the light reflected by the spatial light modulator 60 is changed. When the distribution of angles of the light reflected by the spatial light modulator 60 changes, a degree of coincidence of paths of light before and after the reflection in the spatial light modulator 60 changes. In the spatial light modulator 60, as the degree of coincidence between the curvature radius of the Fresnel lens pattern and a distance between the spatial light modulator 60 and the diffraction grating 50 is higher, a wavelength band in which the paths of light before and after the reflection in the spatial light modulator 60 coincide with each other (a wavelength band in which coupling efficiency to the light source 11 is high) becomes wider. As described above, the spatial light modulator 60 can control the bandwidth of the light returned from the diffraction grating 50 to the light source 11 by controlling the distribution of angles of the reflected light based on the control signal. That is, the spatial light modulator 60 can control a spread of an optical spectrum by changing the focal length of the Fresnel lens pattern. As described above, the spatial light modulator 60 can control the spread of the optical spectrum without moving or aligning the optical components. Note that the bandwidth of the light returned to the light source 11 is determined from, for example, the wavelength dependency of the coupling efficiency to the light source 11, the emission spectrum of the light source 11, and the wavelength dependency of the transmittance of the spatial filter such as the pinhole 92 (for example, the transmittance of the spatial filter at each wavelength of the light returned from the diffraction grating 50 to the light source 11).

In a case of a reflective liquid crystal spatial light modulator, phase modulation by the spatial light modulator 60 is strongly affected by polarized light. The spatial light modulator 60 is disposed such that a polarization direction in which the phase modulation can be performed is an x direction or a y direction (that is, a direction parallel to a reflecting surface 60a in the spatial light modulator 60) in FIG. 1. The spatial light modulator 60 may be disposed such that the reflecting surface 60a and the reflecting surface in the diffraction grating 50 are parallel, or may be disposed so as not to be parallel. The polarization direction in which the phase modulation can be performed in the spatial light modulator 60 is made to coincide with, for example, a linear polarization direction of the light output from the light source 11. Furthermore, in the spatial light modulator 60, adjustment of an optical system or adjustment of a modulation pattern position may be performed such that a normal line extending from a center of the modulation pattern passes through a beam center of the light on the diffraction grating 50. The spatial light modulator 60 and the diffraction grating 50 may be disposed such that a curvature center related to the reflecting surface 60a of the spatial light modulator 60 coincides with the beam center of the light incident on the diffraction grating 50. More specifically, the spatial light modulator 60 and the diffraction grating 50 may be disposed such that a trajectory of the curvature center in a case where a curvature radius related to the reflecting surface 60a of the spatial light modulator 60 is changed intersects the beam center of the light incident on the diffraction grating 50. The curvature center related to the reflecting surface 60a of the spatial light modulator 60 is the curvature center of the modulation pattern displayed on the spatial light modulator 60.

The spatial light modulator 60 may display a predetermined surface shape correction pattern superimposed on the modulation pattern as necessary. Herein, the surface shape correction pattern is a pattern for correcting a shape of the reflecting surface 60a of the spatial light modulator 60. The spatial light modulator 60 may further superimpose and display a pattern for correcting aberration generated in the optical system. In addition, the spatial light modulator 60 may display modulation patterns (Fresnel lens patterns) having different focal lengths in the x direction and the y direction. In this case, for example, by optimizing the focal length in the y direction, the coupling efficiency of the light returned to the light source 11 can be increased. Note that in the spatial light modulator 60, the above-described control of the bandwidth of light (spread control of the optical spectrum) may be performed by changing only the focal length in the x direction.

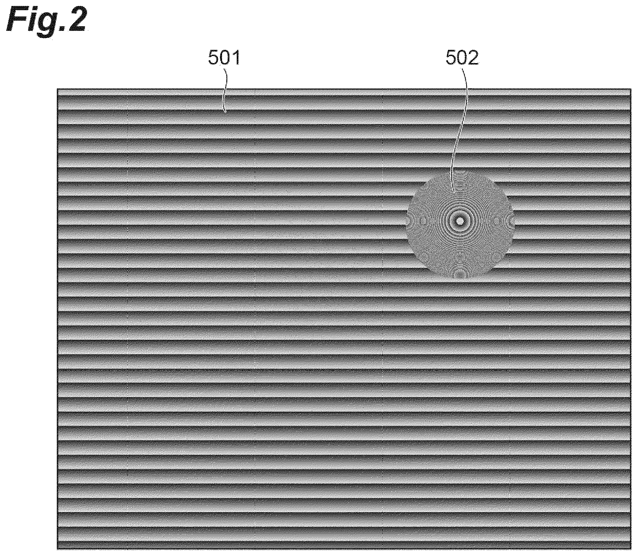

In the spatial light modulator 60, there is a problem that unmodulated light appears as 0th order light. As a countermeasure against such a problem, as illustrated in FIG. 2, a pattern in which a blazed diffraction grating pattern is superimposed on the Fresnel lens pattern may be used as the modulation pattern displayed on the spatial light modulator 60. FIG. 2 illustrates a blazed diffraction grating pattern 501 and a pattern 502 in which the blazed diffraction grating pattern is superimposed on the Fresnel lens pattern. In this case, +1-order light diffracted by the pattern 502 in which the blazed diffraction grating pattern is superimposed on the Fresnel lens pattern may be returned to the light source 11.

The pinhole 92 is a spatial filter that causes only a part of the light returned from the diffraction grating 50 in a spatially dispersed state (separated for each wavelength) to pass therethrough, to limit the wavelength of the light returned to the light source 11. The spatial filter herein may be a unit that functions as a mask in which light transmittance has a spatial distribution. Note that the spatial filter may be a unit including the pinhole 92 and the lens 40, but herein, the pinhole 92 is the spatial filter. The pinhole 92 is provided, for example, at the condensing point of the lens 40. The pinhole 92 is a shielding object in which a circular hole 92a is formed, and is a spatial filter that causes only light having a wavelength spatially corresponding to the position of the hole 92a to pass therethrough and does not cause light having other wavelength to pass therethrough. The diameter of the hole 92a of the pinhole 92 may be, for example, 1 mm or less. The size of the hole 92a of the pinhole 92 may be set according to the specification of the lens 40.

Note that the light returned to the light source 11 through the pinhole 92 is reflected by the light source 11 and passes through the pinhole 92 (spatial filter) again. However, since the light is no longer in a dispersion state when condensed to the light source 11, the wavelength is not limited when passing through the pinhole 92 again.

A lens 91 is provided between the light source 11 and the pinhole 92. The light emitted from the light source 11 travels toward the pinhole 92 via the lens 91. The light returned from the diffraction grating 50 travels toward the pinhole 92 via the lens 40.

Next, the functions and effects of the light source apparatus 1 according to the present embodiment will be described.

A light source apparatus 1 includes: a light source 11 configured to output light; a spatial light modulator 60 including an input unit for a control signal and configured to be able to control distribution of angles at which incident light is reflected based on the control signal; a diffraction grating 50 configured to disperse the light output from the light source 11 to cause the light to be incident on the spatial light modulator 60, and return at least a part of the light reflected by the spatial light modulator 60 to the light source 11; and a pinhole 92 configured to cause only a part of the light returned from the diffraction grating 50 in a spatially dispersed state to pass therethrough. In the light source apparatus 1, an optical resonator is formed by the light source 11 and the spatial light modulator 60, and the light passing through the pinhole 92 and returned to the light source 11 is output.

In the light source apparatus 1 according to the present embodiment, the light output from the light source 11 is dispersed in the diffraction grating 50 and incident on the spatial light modulator 60. Then, at least a part of the light reflected by the spatial light modulator 60 is returned from the diffraction grating 50 to the light source 11. Herein, the pinhole 92 that causes only a part of the light returned from the diffraction grating 50 in a spatially dispersed state to pass therethrough is provided between the diffraction grating 50 and the light source 11, and the light passing through the pinhole 92 and returned to the light source 11 is output. As described above, since the pinhole 92 which is the spatial filter is provided between the diffraction grating 50 and the light source 11, the wavelength of the light returned to and output from the light source 11 is limited. Since the pinhole 92 has a wavelength limiting function, the wavelength limiting function is not required for the light source 11 (or the optical fiber added in the optical resonator, or the like), and various light sources 11 can be used. As described above, according to the present embodiment, it is possible to provide the light source apparatus 1 in which the element used as the light source 11 is not limited.

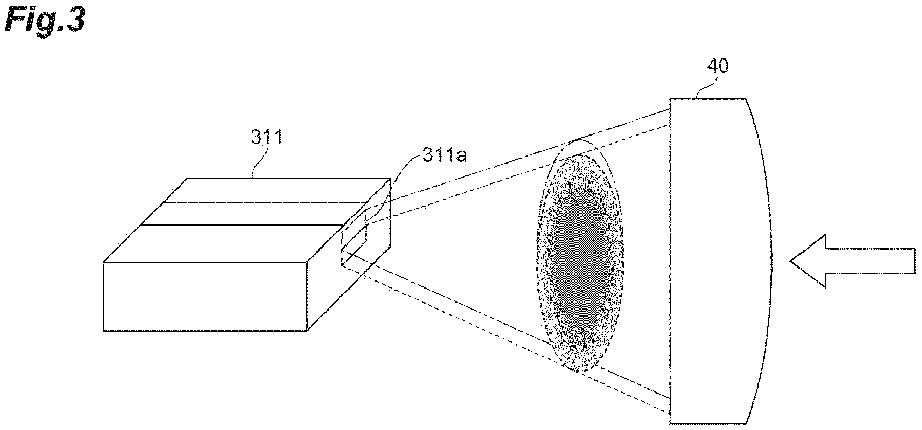

FIG. 3 is a diagram illustrating the wavelength limiting function of a single-mode LD. As illustrated in FIG. 3, when a single-mode LD311 is used as the light source, the light returned from the diffraction grating 50 is coupled to the single-mode LD311, so that the wavelength of the light is limited. As described above, in the configuration in which the light source has the wavelength limiting function, the type of the light source is limited. In this regard, as described above, in the light source apparatus 1 according to the present embodiment, the pinhole 92 has the wavelength limiting function, and the light source is not required to have the wavelength limiting function, so that the element used as the light source is not limited.

In the light source apparatus 1, since the pinhole 92 is adopted as the spatial filter, only a part of the spatially dispersed light can be caused to appropriately pass therethrough. That is, since only the light of the wavelength component at the position corresponding to the hole 92a of the pinhole 92 passes through the pinhole 92, it is possible to appropriately limit the light to only the light of the wavelength component corresponding to the hole 92a of the pinhole 92.

The light source apparatus 1 may include the lens 40 configured to condense the light returned from the diffraction grating 50, and the pinhole 92 (specifically, the hole 92a of the pinhole 92) may be provided at the condensing point of the lens 40. Such a configuration can appropriately perform wavelength limitation provided by the pinhole 92.

In the light source apparatus 1, the bandwidth of the light returned from the diffraction grating 50 to the light source 11 may be controlled by controlling the distribution of angles of the light reflected by the spatial light modulator 60 based on the control signal. According to such a configuration, by changing the control signal, the distribution of angles at which the light is reflected by the spatial light modulator 60 is changed, and the bandwidth of the light returned from the diffraction grating 50 to the light source 11 can be changed. That is, according to such a configuration, the bandwidth of the light returned from the diffraction grating 50 to the light source 11 can be arbitrarily adjusted.

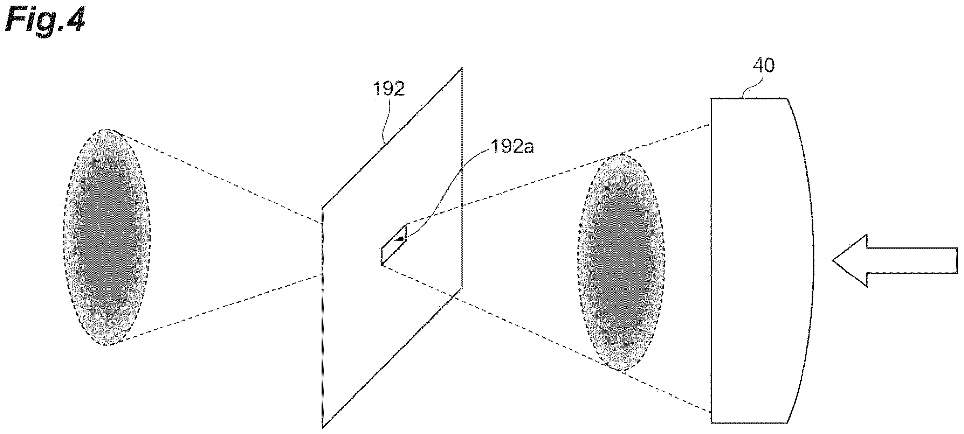

Although the present embodiments have been described above, the present disclosure is not limited to the above embodiments. For example, the description has been given assuming that the pinhole 92 (see FIG. 1) is used as the spatial filter, but the spatial filter is not limited thereto, and may be a transmission mask 192 as illustrated in FIG. 4. Similarly to the pinhole 92 described above, the transmission mask 192 causes only a part of the light returned from the diffraction grating 50 in a spatially dispersed state to pass therethrough in the direction of the light source 11. The transmission mask 192 has, for example, a rectangular shape, and a rectangular transmission region 192a is formed in a central portion thereof. In such a configuration, since only the light of the wavelength component at the position corresponding to the transmission region 192a of the transmission mask 192 passes through the transmission mask 192, it is possible to appropriately limit the light to only the light of the wavelength component corresponding to the transmission region 192a of the transmission mask 192. Note that the shape of the transmission region 192a is not limited to a rectangle, but for example, by having a shape conforming to the shape of the emission end of the light source 11, the utilization efficiency of light can be improved.

For example, in a case where it is desired to realize a wavelength limiting function equivalent to that of the above-described single-mode LD311 (see FIG. 3) by the spatial filter, a rectangular transmission mask 192 may be placed at the condensing point of the lens 40. In this case, the size and shape of the transmission region 192a of the transmission mask 192 may match the size and shape of an emitter opening 311 a (see FIG. 3) of the single-mode LD. The size of the transmission region 192a in the transmission mask 192 may be set according to the specification of the lens 40.

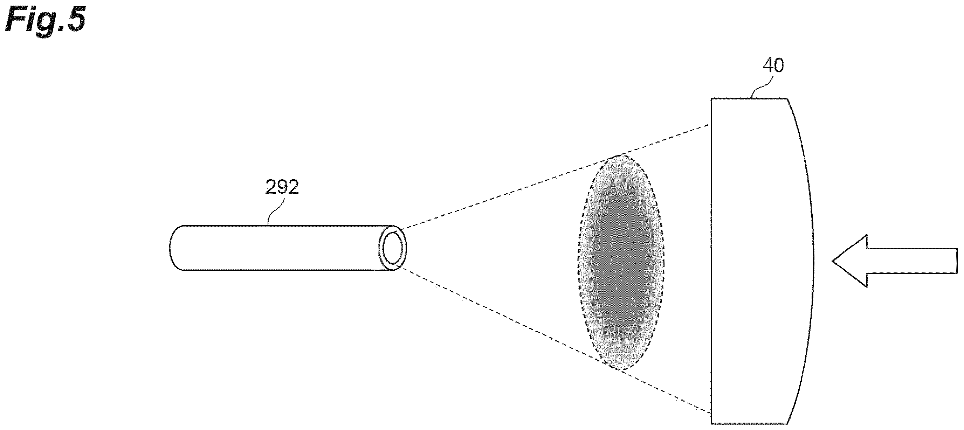

As illustrated in FIG. 5, the spatial filter may be a single-mode fiber 292. Similarly to the pinhole 92 or the transmission mask 192 described above, the single-mode fiber 292 causes only a part of the light returned from the diffraction grating 50 in a spatially dispersed state to pass therethrough in the direction of the light source 11. The single-mode fiber 292 propagates only light of a predetermined wavelength component. According to such a single-mode fiber 292, wavelength limitation can be appropriately performed.

When it is desired to realize a wavelength limiting function equivalent to that of the single-mode fiber 292 by the pinhole 92 described above, the pinhole 92 may be placed at the condensing point of the lens 40, and the size of the hole 92a of the pinhole 92 may be set to be equal to or larger than the mode diameter of the single-mode fiber 292 or equal to or smaller than three times the mode diameter.

Note that, in a configuration in which an optical fiber is provided in an optical resonator, for example, in a case where the spatial filter such as the pinhole 92 or the transmission mask 192 described above is provided, an optical fiber other than the single-mode, for example, a highly non-linear fiber can be used because a wavelength limiting function is not required for the optical fiber. For example, a non-linear effect is likely to occur by using the highly non-linear fiber. Examples of the non-linear effect include self-phase modulation, cross-phase modulation, modulation instability, stimulated Raman scattering, stimulated Brillouin scattering, four-wave mixing, supercontinuum generation, and the like. By using these non-linear effects, a degree of freedom of spectrum control of light is improved, for example, by further expanding the spectrum.

The spatial filter may include one or a plurality of slits (not illustrated). Even such a slit can cause only a part of the light returned from the diffraction grating 50 in a spatially dispersed state to pass therethrough in the direction of the light source 11. Thus, wavelength limitation can be appropriately performed.

### Reference Signs List

- 1: Light source apparatus
- 11: Light source
- 40: Lens (condenser lens)
- 50: Diffraction grating
- 60: Spatial light modulator (reflection unit)
- 92: Pinhole (spatial filter)
- 192: Transmission mask (spatial filter)
- 292: Single-mode fiber (spatial filter)

## Claims

1. A light source apparatus comprising:
a light source configured to output light;
a reflection unit including an input unit for a control signal and configured to be able to control distribution of angles at which incident light is reflected based on the control signal;
a diffraction grating configured to disperse the light output from the light source to cause the light to be incident on the reflection unit, and configured to return, to the light source, at least a part of the light reflected by the reflection unit; and
a spatial filter configured to cause only a part of the light returned from the diffraction grating in a spatially dispersed state to pass therethrough,
wherein
an optical resonator including the light source and the reflection unit is formed, and the light passing through the spatial filter and returned to the light source is output.

2. The light source apparatus according to claim 1, wherein the spatial filter is a pinhole, a transmission mask, one or a plurality of slits, or a single-mode fiber.

3. The light source apparatus according to claim 2, further comprising a condenser lens configured to condense the light returned from the diffraction grating,
wherein the spatial filter is provided at a condensing point of the condenser lens.

4. The light source apparatus according to any one of claims 1 to 3, wherein a bandwidth of the light returned from the diffraction grating to the light source is controlled by controlling distribution of angles of the light reflected by the reflection unit based on the control signal.
